# EUROPÄISCHE PATENTANMELDUNG

(11) **EP 4 379 789 A1**
(43) Veröffentlichungstag der Anmeldung: **05.06.2024**
(21) Anmeldenummer: 22210598.3
(22) Anmeldetag: 30.11.2022
(51) Int. Cl.: H01L 23/053, H01L 23/20, H01L 23/22, H01L 23/24

(54) **HALBLEITERANORDNUNG MIT ZUMINDEST EINEM HALBLEITERELEMENT**

(71) Anmelder: Siemens Aktiengesellschaft, 80333 München (DE)
(72) Erfinder: NEUGEBAUER, Stephan, 91058 Erlangen (DE); RAAB, Oliver, 94496 Ortenburg (DE); RADÜGE, Christian, 90425 Nürnberg (DE); STEGMEIER, Stefan, 81825 München (DE); WAGNER, Claus Florian, 90425 Nürnberg (DE); WOITON, Michael, 90425 Nürnberg (DE)
(74) Vertreter: Siemens Patent Attorneys

(57) **Zusammenfassung**

Die Erfindung betrifft eine Halbleiteranordnung (2), insbesondere Leistungshalbleiteranordnung für einen Stromrichter (50), mit zumindest einem Halbleiterelement (4), wobei das zumindest eine Halbleiterelement (4) in einem, insbesondere geschlossenen, Gehäuse (6) angeordnet ist. Um die Rezyklierbarkeit einer Halbleiteranordnung (2) zu verbessern, wird vorgeschlagen, dass das Gehäuse (6) zumindest teilweise mit einem rieselfähigen Werkstoff (30) gefüllt ist, welcher elektrisch isolierende Partikel (44) enthält und mit dem zumindest einen Halbleiterelement (4) in unmittelbarem Kontakt steht.

## Beschreibung

Die Erfindung betrifft eine Halbleiteranordnung, insbesondere eine Leistungshalbleiteranordnung für einen Stromrichter, mit zumindest einem Halbleiterelement.

Ferner betrifft die Erfindung einen Stromrichter mit mindestens einer derartigen Halbleiteranordnung.

Überdies betrifft die Erfindung ein Verfahren zur Herstellung einer Halbleiteranordnung, insbesondere einer Leistungshalbleiteranordnung für einen Stromrichter, mit zumindest einem Halbleiterelement.

Darüber hinaus betrifft die Erfindung die Verwendung eines rieselfähigen Werkstoffs, welcher elektrisch isolierende Partikel enthält, zum Befüllen eines Gehäuses einer Halbleiteranordnung.

Derartige Halbleiteranordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Üblicherweise umfassen derartige Halbleiteranordnungen ein Gehäuse, in welchem zumindest ein Halbleiterelement angeordnet ist. Ein derartiges Halbleiterelement kann unter anderem ein Transistor sein. Innerhalb des Gehäuses ist üblicherweise ein Weichverguss, insbesondere ein Silikonverguss, zum Schutz des zumindest einen Halbleiterelements vorgesehen.

Die Offenlegungsschrift WO 2022/033745 A1 beschreibt ein Leistungsmodul mit mindestens einer Leistungseinheit, welche mindestens einen Leistungshalbleiter und ein Substrat umfasst, wobei die mindestens eine Leistungseinheit zumindest teilweise von einem Gehäuse umgeben ist. Das Gehäuses ist mit einem Weichverguss, insbesondere mit einem Silikonverguss, gefüllt.

Umwelttechnische Aspekte gewinnen auch in der Elektronikentwicklung immer mehr an Bedeutung. Insbesondere rückt eine verbesserte Rezyklierbarkeit in den Fokus. Die Rezyklierbarkeit aber auch ein Reparaturaufwand werden beispielsweise durch den Wegfall von stoffschlüssigen Verbindungen, welche beispielsweise durch Löten, Sintern oder Schweißen herstellbar sind, verbessert.

Die Offenlegungsschrift EP 3 926 670 A1 beschreibt ein Leistungshalbleitermodul mit zumindest einem Leistungshalbleiterelement. Um den erforderlichen Bauraum des Leistungshalbleitermoduls zu verringern und dessen Lebensdauer zu erhöhen, wird vorgeschlagen, dass das zumindest eine Leistungshalbleiterelement über eine dielektrische Materiallage mit einem Kühlelement in einer elektrisch isolierenden und thermisch leitfähigen Verbindung steht, wobei die dielektrische Materiallage flächig auf einer Oberfläche des Kühlelements aufliegt und mittels einer orthogonal zur Oberfläche des Kühlelements wirkenden ersten Kraft kraftschlüssig mit dem Kühlelement verbunden ist.

Die Offenlegungsschrift WO 2018/046165 A1 beschreibt ein Leistungsmodul mit einem ober- und unterseitig zu kontaktierenden Halbleiterbauelement, wobei das Halbleiterbauelement oberseitig durch eine Leadframe-Matrix mittels Anpressdruck elektrisch zu kontaktieren ist.

Ein Weichverguss ist, beispielsweise bei Rezyklierungsvorgängen, sehr schwer zu entfernen. Vor diesem Hintergrund ist es eine Aufgabe der vorliegenden Erfindung, die Rezyklierbarkeit einer Halbleiteranordnung zu verbessern.

Diese Aufgabe wird erfindungsgemäß gelöst durch eine Halbleiteranordnung, insbesondere eine Leistungshalbleiteranordnung für einen Stromrichter, mit zumindest einem Halbleiterelement, wobei das zumindest eine Halbleiterelement in einem, insbesondere geschlossenen, Gehäuse angeordnet ist, wobei das Gehäuse zumindest teilweise mit einem rieselfähigen Werkstoff gefüllt ist, welcher elektrisch isolierende Partikel enthält und mit dem zumindest einen Halbleiterelement in unmittelbarem Kontakt steht.

Ferner wird die Aufgabe erfindungsgemäß gelöst durch einen Stromrichter mit mindestens einer derartigen Halbleiteranordnung.

Überdies wird die Aufgabe erfindungsgemäß gelöst durch Verfahren zur Herstellung einer Halbleiteranordnung, insbesondere einer Leistungshalbleiteranordnung für einen Stromrichter, mit zumindest einem Halbleiterelement, wobei das zumindest eine Halbleiterelement in einem Gehäuse angeordnet wird, wobei das Gehäuse zumindest teilweise mit einem rieselfähigen Werkstoff, welcher elektrisch isolierende Partikel enthält, derartig befüllt wird, dass der rieselfähige Werkstoff mit dem zumindest einen Halbleiterelement in unmittelbarem Kontakt steht, wobei das Gehäuse in einem weiteren Schritt verschlossenen wird.

Darüber hinaus wird die Aufgabe erfindungsgemäß gelöst durch die Verwendung eines rieselfähigen Werkstoffs, welcher elektrisch isolierende Partikel enthält, zum Befüllen eines Gehäuses einer Halbleiteranordnung, in welchem zumindest ein Halbleiterelement angeordnet ist, wobei das Befüllen derartig erfolgt, dass der rieselfähige Werkstoff mit dem zumindest einen Halbleiterelement in unmittelbarem Kontakt steht.

Die in Bezug auf die Halbleiteranordnung nachstehend angeführten Vorteile und bevorzugten Ausgestaltungen lassen sich sinngemäß auf den Stromrichter, das Herstellungsverfahren und die Verwendung übertragen.

Der Erfindung liegt die Überlegung zugrunde, die Rezyklierbarkeit einer Halbleiteranordnung dadurch zu verbessern, dass ein üblicherweise verwendeter Weichverguss durch einen rieselfähigen Werkstoff, welcher elektrisch isolierende Partikel enthält, ersetzt wird. Ein Gehäuse der Halbleiteranordnung, in welchem zumindest ein Halbleiterelement angeordnet ist, wird zumindest teilweise mit dem rieselfähigen Werkstoff derartig befüllt, dass das Halbleiterelement mit dem rieselfähigen Werkstoff in unmittelbarem Kontakt steht. Insbesondere ist das Halbleiterelement zumindest teilweise vom rieselfähigen Werkstoff umgeben. Der rieselfähige Werkstoff kann z.B. Quarzsand, Karbonatsand, Gipssand, Silikate, aber auch organische rieselfähige Stoffe, z.B. Polymere, Siloxane enthalten. Der rieselfähige Werkstoff kann durch seine sandartige Struktur, insbesondere im Vergleich zum üblicherweise verwendeten Weichverguss, deutlich leichter entfernt werden. Ein einfaches Zerlegen zur Reparatur, zum Refurbishing oder zum Rezyklieren wird durch eine derartige rieselfähige Füllung ermöglicht. Ferner werden Materialien und energieintensive Herstellungsprozesse eingespart.

Eine weitere Ausführungsform sieht vor, dass die elektrisch isolierenden Partikel des rieselfähigen Werkstoffs eine Korngröße im Bereich von 0,01 mm bis 0,6 mm, insbesondere 0,1 mm bis 0,4 mm, aufweisen. Insbesondere liegt eine mittlere Korngröße im Bereich von 0,2 mm bis 0,3 mm. Durch eine derartige Korngröße werden Luftzwischenräume minimiert und es wird unter anderem eine ausreichende Isolationswirkung erreicht. Insbesondere können Zwischenräume mit einer bimodalen oder höheren Mischungen des rieselfähigen Werkstoffs minimiert werden, was die Isolationswirkung zusätzlich verbessert.

Eine weitere Ausführungsform sieht vor, dass die elektrisch isolierenden Partikel des rieselfähigen Werkstoffs ein Metalloxid enthalten. Beispielsweise enthalten die elektrisch isolierenden Partikel Aluminium- und/oder Titanoxid, Glas-, Glimmer- und/oder Keramik-Partikel. Durch derartige Metalloxide ist eine gute Isolationswirkung erreichbar. Bei der Verwendung von anorganischen elektrisch isolierenden Partikeln wie Aluminiumoxid-Sand weist die Halbleiteranordnung einen erhöhten Explosionsschutz auf, da anorganische Werkstoffe signifikant weniger, insbesondere kaum, Explosionsgase verursacht, folglich kein Kohlendioxid oder Wasser entsteht und Druckkräfte besser aufgenommen werden können.

Eine weitere Ausführungsform sieht vor, dass die elektrisch isolierenden Partikel des rieselfähigen Werkstoffs eine scharf gebrochene, insbesondere zerklüftete, Oberfläche aufweisen. Eine derartige Oberfläche führt, insbesondere im Vergleich zu einer sphärischen Struktur, zu einer Verlängerung der Kriechwege

Eine weitere Ausführungsform sieht vor, dass der rieselfähige Werkstoff mit einem schmelzbaren Isolationsmaterial, insbesondere einem Wachs, verfüllt ist. Hierfür kommen beispielsweise hochschmelzende Paraffine oder andere Wachse, insbesondere mit einem Schmelzpunkt oberhalb von 100°C, infrage. Beispielsweise werden Zwischenräume mit dem schmelzbaren Isolationsmaterial verfüllt, wobei das Material während des Aufschmelzens in die Partikel-Zwischenräume kriecht, die Luft verdrängt und beim Abkühlen aushärtet. Durch diesen Aufbau wird die Durchbruchspannung des Moduls wesentlich erhöht. Insbesondere ein mehrfach schmelzbares Isolationsmaterial, wie ein Wachs, ist im geschmolzenen Zustand relativ dünnflüssig und, z.B. bei einem Rezykliervorgang, einfach zu entfernen. Darüber hinaus sind Paraffine oder andere Wachse biologisch abbaubar und/oder wiederverwendbar.

Eine weitere Ausführungsform sieht vor, dass der rieselfähige Werkstoff mit einem isolierende Fluid verfüllt ist. Derartige isolierende Fluide sind beispielsweise Fluorkohlenwasserstoffe wie 3M Novec. Durch derartige isolierende Fluid ist ein Schlamm ausbildbar, welcher beim Zerlegen zur Reparatur, zum Refurbishing oder zum Rezyklieren einfach entfernbar ist und die Isolationswirkung verbessert. Ferner kann das isolierende Fluid ein elektrisch isolierendes Gas sein, das Zwischenräume des rieselfähigen Werkstoffs ausfüllt, um eine noch höhere Isolationswirkung zu erreichen.

Eine weitere Ausführungsform sieht vor, dass das isolierende Fluid ein Phasenwechselmaterial enthält, wodurch Wärmespitzen abgefedert werden können.

Eine weitere Ausführungsform sieht vor, dass in dem Gehäuse ein einem Schaltungsträger angeordnet ist, wobei das Halbleiterelement, insbesondere mittels eines Presskontakts, kraftschlüssig mit dem Schaltungsträger verbunden ist. Ein derartiger Presskontakt kann unter anderem als Stromschiene, welche auch Busbar genannt wird, ausgeführt sein. Alternativ kann eine Feder, eine Schraube und/oder ein Bügel zur kraftschlüssigen Verbindung des Halbleiterelements zum Einsatz kommen. Ein Schaltungsträger kann unter anderem ein Substrat, insbesondere ein DCB (Direct Copper Bonded) Substrat, sein. Eine derartige kraftschlüssige Verbindung des Halbleiterelements ist lösbar und beim Zerlegen zur Reparatur, zum Refurbishing oder zum Rezyklieren, insbesondere in Kombination mit der Füllung aus dem rieselfähigen Werkstoff, einfach zu entfernen.

Eine weitere Ausführungsform sieht vor, dass das Gehäuse einen Kühlkörper umfasst auf welchem der Schaltungsträger flächig aufliegt, wobei der Schaltungsträger kraftschlüssig mit Kühlkörper verbunden ist. Eine derartige kraftschlüssige Verbindung ist unter anderem durch Anpressen herstellbar und erleichtert das Zerlegen beispielsweise zum Rezyklieren.

Eine weitere Ausführungsform sieht vor, dass der Schaltungsträger, insbesondere über eine Ölschicht, lösbar und thermisch leitfähig mit dem Kühlkörper verbunden ist. Eine derartige Ölschicht stellt eine lösbare Verbindung des Schaltungsträgers mit dem Kühlkörper her und gleicht die Oberflächenrauigkeit der Oberflächen des Kühlkörpers bzw. des Schaltungsträgers aus. Insbesondere ein thermisch leitfähiges Öl der Ölschicht verbessert die thermische Anbindung des Schaltungsträgers an den Kühlkörper.

Eine weitere Ausführungsform sieht vor, dass das Halbleiterelement auf einer dem Schaltungsträger abgewandten Seite mindestens einen Kontakt aufweist, wobei der mindestens eine Kontakt von einem, insbesondere aufgeklebten oder aufgepressten, Kunststoffrahmen umgeben ist. Ein derartiger Kunststoffrahmen verbessert, insbesondere für HV-Leistungsmodule, eine Isolationsstrecke.

Eine weitere Ausführungsform sieht vor, dass auf zumindest einem der Kontakte des Halbleiterelements ein metallisches Kontaktierungselement aufliegt und über einen Presskontakt zur kraftschlüssigen Kontaktierung des Halbleiterelements angepresst wird. Beispielsweise ist das metallische Kontaktierungselement als Kupferplättchen oder Molybdänplättchen ausgeführt, das eine Dicke im Bereich von 10 µm bis 250 µm, insbesondere 25 µm bis 250 µm, aufweist. Das metallische Kontaktierungselement fungiert als Druckbuffer, welches Druckkräfte, z.B. vom Presskontakt, verteilt, sodass das Einleiten von Druckspitzen in den empfindliche Halbleiterelement verhindert wird. Eine derartige Anordnung mit einem kraftschlüssig verbundenen Druckbuffer erleichtert das Zerlegen beispielsweise zum Rezyklieren.

Im Folgenden wird die Erfindung anhand der in den Figuren dargestellten Ausführungsbeispiele näher beschrieben und erläutert.

Es zeigen:
- FIG 1: eine schematische Schnittdarstellung einer ersten Ausführungsform einer Halbleiteranordnung,
- FIG 2: eine schematische Schnittdarstellung einer zweiten Ausführungsform einer Halbleiteranordnung,
- FIG 3: eine vergrößerte schematische Darstellung einer ersten Ausführungsform eines rieselfähigen Werkstoffs,
- FIG 4: eine vergrößerte schematische Darstellung einer zweiten Ausführungsform eines rieselfähigen Werkstoffs,
- FIG 5: eine vergrößerte schematische Darstellung einer dritten Ausführungsform eines rieselfähigen Werkstoffs,
- FIG 6: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

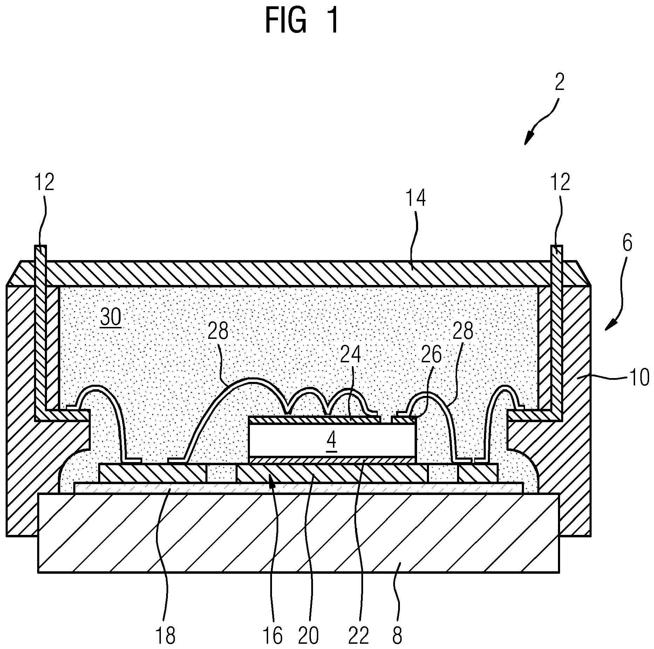

FIG 1 zeigt eine schematische Schnittdarstellung einer ersten Ausführungsform einer Halbleiteranordnung 2 mit einem Halbleiterelement 4, welches in einem geschlossenen Gehäuse 6 angeordnet ist. Beispielsweise ist das Halbleiterelement 4 als vertikaler Transistor, insbesondere als IGBT oder vertikaler SiC-MOSFET, ausgeführt. Das Gehäuse 6 umfasst einen metallischen Kühlkörper 8, einen Gehäuserahmen 10 mit einer Mehrzahl von Pins 12 und einem Gehäusedeckel 14. Der Gehäuserahmen 10 und der Gehäusedeckel 14 sind beispielsweise aus einem Kunststoff hergestellt, wobei die Pins 12 in den Gehäuserahmen 10 eingegossen oder eingepresst sind. Der Kühlkörper 8, welcher als Bodenplatte fungiert, ist beispielsweise aus Kupfer, Aluminium oder einer deren Legierungen hergestellt. Ein Schaltungsträger 16 ist flächig mit dem Kühlkörper 8 verbunden. Beispielhaft umfasst der Schaltungsträger 16 eine dielektrisehe Materiallage 18, welche insbesondere Aluminiumoxid, Aluminiumnitrid oder einen organischen elektrisch isolierenden und thermisch leitfähigen Werkstoff enthält, und eine Metallisierung 20, welche beispielsweise Kupfer, Gold, Molybdän, Silber oder eine deren Legierungen enthält. Die dielektrische Materiallage 18 kann mit dem Kühlkörper verpresst oder adhäsiv verbunden sein. Alternativ kann der Schaltungsträger 16 als Substrat, insbesondere als DCB (Direct Copper Bonded) Substrat, ausgeführt sein, welches beispielsweise auf dem Kühlkörper 8 aufgelötet ist.

Das Halbleiterelement 4 weist einen ersten Leistungskontakt 22, insbesondere einen Kollektor-Kontakt, und auf einer gegenüberliegenden Seite einen zweiten Leistungskontakt 24, insbesondere einen Emitter-Kontakt, und einen Steuerkontakt 26, insbesondere einen Gate-Kontakt, auf. Der erste Leistungskontakt 22 des Halbleiterelements 4 ist beispielsweise stoffschlüssig mit der Metallisierung 20 des Schaltungsträgers 16 verbunden. Die stoffschlüssige Verbindung des Halbleiterelements 4 mit dem Schaltungsträger 16 ist unter anderem durch Löten und/oder Sintern herstellbar. Der auf einer dem Schaltungsträger 16 abgewandten Seite des Halbleiterelements 4 angeordnete zweite Leistungskontakt 24 und Steuerkontakt 26 sind jeweils über Verdrahtungsmittel 28 mit der Metallisierung 20 des Schaltungsträgers 16 verbunden, wobei die Metallisierung 20 mit den Pins 12 des Gehäuses 6 verdrahtet ist. Auf diese Weise werden die Kontakte 22, 24, 26 des Halbleiterelements 4 aus dem Gehäuse 6 herausgeführt und sind über die Pins 12 von außerhalb elektrisch leitend kontaktierbar. Die Verdrahtungsmittel 28 sind beispielsweise als Bonddrähte oder Bondbänder ausgeführt, welche insbesondere durch Ultraschall-Drahtbonden verschweißt werden.

Das Gehäuse 6 ist, beispielhaft vollständig, mit einem rieselfähigen Werkstoff 30 gefüllt, welcher elektrisch isolierende Partikel enthält, mit dem Halbleiterelement 4 in unmittelbarem Kontakt steht und diesen teilweise umgibt. Der rieselfähige Werkstoff 30 kann unter anderem einen rieselfähigen Sand enthalten, der elektrisch isolierende Partikel aus einem Metalloxid, z.B. Aluminiumoxid, enthält. Zusätzlich oder alternativ kann der rieselfähige Werkstoff 30 weitere anorganische Stoffe, z.B. Quarzsand, Karbonatsand, Gipssand, Silikate, aber auch organische rieselfähige Stoffe, z.B. Polymere, Siloxane enthalten. Insbesondere weisen die elektrisch isolierenden Partikel des rieselfähige Werkstoffs 30 eine Korngröße im Bereich von 0,01 mm bis 0,6 mm, insbesondere 0,1 mm bis 0,4 mm, auf. Eine mittlere Korngröße kann unter anderem bei 0,2 mm bis 0,3 mm liegen. Der rieselfähige Werkstoff 30 ersetzt in der Halbleiteranordnung 2 eine üblicherweise verwendete Vergussmasse, welche beispielsweise aus einem schwer entfernbaren Silikonisolationsmaterial hergestellt ist. Der rieselfähige Werkstoff 30 kann nach dem Öffnen des Gehäuses 6 leicht entfernt werden, sodass die Komponenten im Gehäuses 6 für Rezyklierungs- und Reparaturvorgänge frei zugänglich sind.

Optional kann die Sandfüllung mit dem rieselfähigen Werkstoff 30 geschichtet oder anderweitig gradiert sein, wobei die elektrisch isolierenden Partikel für eine verbesserte Trennbarkeit beispielsweise unterschiedliche Dichten aufweisen. Eine Schichtung kann z.B. zu dem Zweck verfolgen, in Bereichen mit unkritischen, elektrischen Feldern kosteneffizientere Füllmaterialien einzusetzen oder zusätzliche Funktionen wie Flammschutz, Lichtbogenlöschung oder Wärmepufferung zu realisieren.

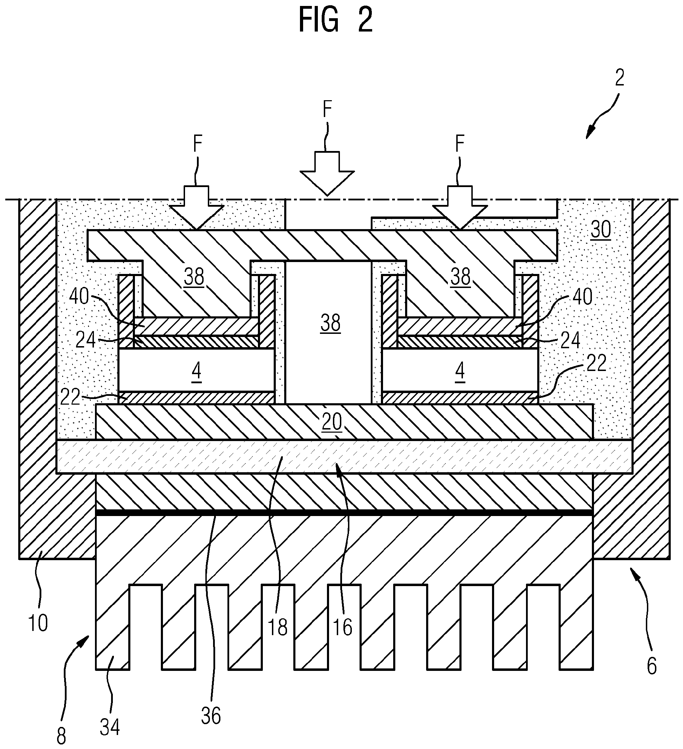

FIG 2 zeigt eine schematische Schnittdarstellung einer zweiten Ausführungsform einer Halbleiteranordnung 2 mit beispielhaft zwei Halbleiterelementen 4, welches in einem geschlossenen Gehäuse 6 angeordnet sind. Das Gehäuse 6 umfasst einen metallischen Kühlkörper 8, einen Gehäuserahmen 10 und einem Gehäusedeckel, welcher aus Gründen der Übersichtlichkeit in FIG 2 nicht dargestellt ist. Ein Schaltungsträger 16, welcher beispielhaft als DCB-Substrat ausgeführt ist und eine dielektrische Materiallage 18 mit einer beidseitigen Metallisierung 20 aufweist, liegt flächig auf dem Kühlkörper 8 auf. Der Kühlkörper weist auf einer dem DCB-Substrat abgewandten Seite Rippen 34 auf. Eine Ölschicht 36 stellt eine lösbare und thermisch leitfähige Verbindung des DCB-Substrats mit dem Kühlkörper her. Das thermisch leitfähige Öl der Ölschicht 36 gleicht die Oberflächenrauigkeit der Oberflächen des Kühlkörpers 8 bzw. des Schaltungsträgers 16 aus und verbessert somit die thermische Anbindung.

Auf den zweiten Leistungskontakten 24 der Halbleiterelemente 4 liegt jeweils ein metallisches Kontaktierungselement 40 auf. Zusätzlich oder alternativ können derartige metallische Kontaktierungselemente 40 zwischen dem Schaltungsträger 16 und dem ersten Leistungskontakt 22 der Halbleiterelemente 4 angeordnet werden. Beispielsweise sind die metallischen Kontaktierungselemente 40 als Kupferplättchen oder Molybdänplättchen ausgeführt, die jeweils eine Dicke im Bereich von 25 µm bis 250 µm aufweisen. Alternativ werden die metallischen Kontaktierungselemente 40 stoffschlüssig, beispielsweise durch Löten oder Sintern, mit dem jeweiligen Halbleiterelement 4 verbunden. Ferner können die metallischen Kontaktierungselemente 40 mittels eines thermischen Spritzverfahrens, insbesondere in Form von Kupfer- und/oder Molybdänpartikeln, aufgesprüht werden.

Mittels Presskontakten 38, welche über die metallischen Kontaktierungselemente 40 mit den zweiten Leistungskontakten 24 der Halbleiterelemente 4 kontaktiert werden, werden die Halbleiterelemente 4 kraftschlüssig und lösbar mit der Metallisierung 20 des Schaltungsträgers 16 verbunden. Die Presskontakte 38 sind in FIG 2 als Stromschienen, welche auch Busbars genannt werden, ausgeführt. Beispielsweise werden die Stromschienen aus Kupfer oder einer Kupferlegierung hergestellt. Zusätzlich oder alternativ können die Presskontakte 38 einen Federkontakt aufweisen. Über die Stromschienen wird eine orthogonal zur Oberfläche des Schaltungsträgers 16 wirkende Kraft F übertragen, mittels welcher die Halbleiterelemente 4 fixiert werden. Das Gehäuse 6 ist, wie in FIG 1 gezeigt, mit einem rieselfähigen Werkstoff 30 gefüllt, welcher elektrisch isolierende Partikel enthält und mit den Halbleiterelementen 4 in unmittelbarem Kontakt steht und diese teilweise umgibt. Beispielhaft enthält der rieselfähigen Werkstoff 30 Quarzsand und/oder Aluminiumoxid-Sand. Optional ist der rieselfähige Werkstoff 30 im Bereich des Gehäusedeckels ganz oder teilweise mit einer Folie bedeckt, die beispielsweise durch ein elastisches Zwischenelement, insbesondere einem Polymerschaum, an den rieselfähigen Werkstoff 30 angedrückt wird. Alternativ wird das elastische Zwischenelement unmittelbar auf den rieselfähigen Werkstoff 30 aufgepresst, sodass ein Verrieseln und somit die Entstehung von Hohlräumen verhindert werden. Gleichzeitig wird eine Nachverdichtung erreicht, was die Isolationswirkung erhöht und sich folglich positiv auf die Betriebssicherheit auswirkt.

Insbesondere für HV-Leistungsmodule sind die zweiten Leistungskontakte 24 der Halbleiterelemente 4 von einem aufgeklebten oder aufgepressten Kunststoffrahmen 42 umgeben, um eine Isolationsstrecke zu verbessern. Alternativ kann der Kunststoffrahmen 42 additiv, beispielsweise durch Dispensen oder ein 3D-Druck-Verfahren, aufgebracht werden. Um Lufteinschlüsse beim Einrieseln des rieselfähigen Werkstoffs 30 zu verhindern, können, beispielsweise in den Presskontakten 38, Bohrungen angebracht werden. Die weitere Ausführung der Halbleiteranordnung 2 in FIG 2 entspricht der Ausführung in FIG 1.

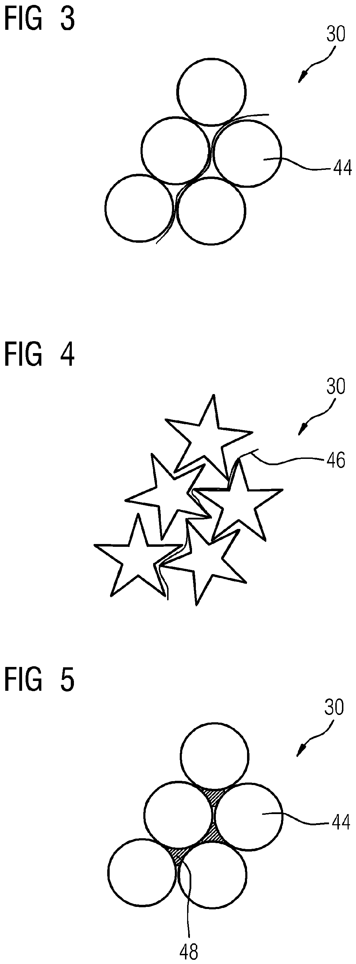

FIG 3 zeigt eine vergrößerte schematische Darstellung einer ersten Ausführungsform eines rieselfähigen Werkstoffs 30, der einen Sand enthält, welcher elektrisch isolierende Partikel 44 mit einer sphärischen Struktur und geringer Korngröße im Bereich von 0,01 mm bis 0,6 mm, insbesondere 0,1 mm bis 0,4 mm, aufweist, was das Einrieseln erleichtert und die Wahrscheinlichkeit von Lufteinschlüssen verringert. Beispielsweise enthält der rieselfähige Werkstoff 30 Quarzsand, insbesondere Sicherungssand. Die weitere Ausführung des rieselfähigen Werkstoffs 30 entspricht der in FIG 1.

FIG 4 zeigt eine vergrößerte schematische Darstellung einer zweiten Ausführungsform eines rieselfähigen Werkstoffs 30, welcher elektrisch isolierenden Partikel 44 mit einer scharf gebrochenen, idealerweise zerklüfteten, Oberfläche aufweist. Durch eine derartige Oberflächenbeschaffenheit werden Kriechstrecken 46, insbesondere im Vergleich zu einer sphärischen Struktur, verlängert. Die weitere Ausführung des rieselfähigen Werkstoffs 30 in FIG 4 entspricht der in FIG 3.

FIG 5 zeigt eine vergrößerte schematische Darstellung einer dritten Ausführungsform eines rieselfähigen Werkstoffs 30, - welcher mit einem schmelzbaren Isolationsmaterial, insbesondere mit einem Wachs, verfüllt ist. Hierfür kommen hochschmelzende Paraffine oder andere Wachse mit einem Schmelzpunkt oberhalb von 100°C infrage. Zusätzlich oder alternativ ist der rieselfähige Werkstoffs 30 mit einem isolierende Fluid, welches Fluorkohlenwasserstoffe, z.B. 3M Novec enthält, verfüllt. Durch das isolierende Fluid wird ein Schlammbildung ausgebildet. Das isolierende Fluid kann als PhasenwechselMaterial ausgeführt sein, um Wärmespitzen abzufedern. Um eine verbesserte Teilentladungsfestigkeit zu gewährleisten und so die Lebensdauer der Halbleiteranordnung 2, kann der rieselfähige Werkstoff 30 einen Werkstoff mit einer hohen Festigkeit gegen Teilentladungen, z.B. Glimmer, enthalten. Die weitere Ausführung des rieselfähigen Werkstoffs 30 in FIG 5 entspricht der in FIG 3. Die Partikel 44 des rieselfähigen Werkstoffs 30 in FIG 5 können zumindest teilweise eine scharf gebrochene, idealerweise zerklüftete, Oberfläche wie in FIG 4 gezeigt, aufweisen.

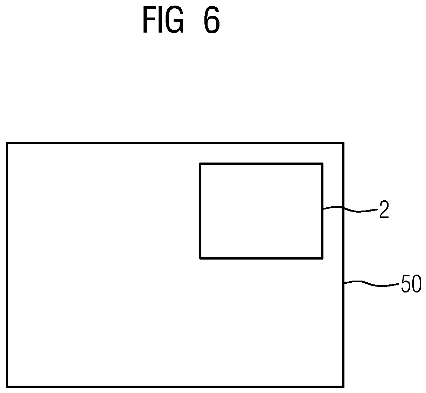

FIG 6 zeigt eine schematische Darstellung eines Stromrichters 50, welcher eine Halbleiteranordnung 2 umfasst. Der Stromrichter 50 kann mehr als eine Halbleiteranordnung 2 umfassen.

Zusammenfassend betrifft die Erfindung eine Halbleiteranordnung 2, insbesondere Leistungshalbleiteranordnung für einen Stromrichter 50, mit zumindest einem Halbleiterelement 4, wobei das zumindest eine Halbleiterelement 4 in einem, insbesondere geschlossenen, Gehäuse 6 angeordnet ist. Um die Rezyklierbarkeit einer Halbleiteranordnung 2 zu verbessern, wird vorgeschlagen, dass das Gehäuse 6 zumindest teilweise mit einem rieselfähigen Werkstoff 30 gefüllt ist, welcher elektrisch isolierende Partikel 44 enthält und mit dem zumindest einen Halbleiterelement 4 in unmittelbarem Kontakt steht.

## Patentansprüche

1. Halbleiteranordnung (2), insbesondere Leistungshalbleiteranordnung für einen Stromrichter (50), mit zumindest einem Halbleiterelement (4),
wobei das zumindest eine Halbleiterelement (4) in einem, insbesondere geschlossenen, Gehäuse (6) angeordnet ist,
wobei das Gehäuse (6) zumindest teilweise mit einem rieselfähigen Werkstoff (30) gefüllt ist, welcher elektrisch isolierende Partikel (44) enthält und mit dem zumindest einen Halbleiterelement (4) in unmittelbarem Kontakt steht.

2. Halbleiteranordnung (2) nach Anspruch 1,
wobei die elektrisch isolierenden Partikel (44) des rieselfähigen Werkstoffs (30) eine Korngröße im Bereich von 0,01 mm bis 0,6 mm, insbesondere 0,1 mm bis 0,4 mm, aufweisen.

3. Halbleiteranordnung (2) nach einem der Ansprüche 1 oder 2, wobei die elektrisch isolierenden Partikel (44) des rieselfähigen Werkstoffs (30) ein Metalloxid enthalten.

4. Halbleiteranordnung (2) nach einem der vorherigen Ansprüche,
wobei die elektrisch isolierenden Partikel (44) des rieselfähigen Werkstoffs (30) eine scharf gebrochene, insbesondere zerklüftete, Oberfläche aufweisen.

5. Halbleiteranordnung (2) nach einem der vorherigen Ansprüche,
wobei der rieselfähige Werkstoff (30) mit einem schmelzbaren Isolationsmaterial, insbesondere einem Wachs, verfüllt ist.

6. Halbleiteranordnung (2) nach einem der Ansprüche 1 bis 4, wobei der rieselfähige Werkstoff (30) mit einem isolierenden Fluid verfüllt ist.

7. Halbleiteranordnung (2) nach Anspruch 4,
wobei das isolierende Fluid ein Phasenwechselmaterial enthält.

8. Halbleiteranordnung (2) nach einem der vorherigen Ansprüche,
wobei in dem Gehäuse (6) ein Schaltungsträger (16) angeordnet ist,
wobei das Halbleiterelement (4), insbesondere mittels eines Presskontakts (38), kraftschlüssig mit dem Schaltungsträger (16) verbunden ist.

9. Halbleiteranordnung (2) nach Anspruch 8,
wobei das Gehäuse (6) einen Kühlkörper (8) umfasst auf welchem der Schaltungsträger (16) flächig aufliegt,
wobei der Schaltungsträger (16) kraftschlüssig mit Kühlkörper (8) verbunden ist.

10. Halbleiteranordnung (2) nach Anspruch 9,
wobei der Schaltungsträger (16), insbesondere über eine Ölschicht (36), lösbar und thermisch leitfähig mit dem Kühlkörper (8) verbunden ist.

11. Halbleiteranordnung (2) nach einem der Ansprüche 8 bis 10,
wobei das Halbleiterelement (4) auf einer dem Schaltungsträger (16) abgewandten Seite mindestens einen Kontakt (22, 24, 26) aufweist,
wobei der mindestens eine Kontakt (22, 24, 26) von einem, insbesondere aufgeklebten oder aufgepressten, Kunststoffrahmen (42) umgeben ist.

12. Halbleiteranordnung (2) nach Anspruch 11,
wobei auf zumindest einem der Kontakte (22, 24, 26) des Halbleiterelements (4) ein metallisches Kontaktierungselement (40) aufliegt und über einen Presskontakt (38) zur kraftschlüssigen Kontaktierung des Halbleiterelements (4) angepresst wird.

13. Stromrichter (50) mit mindestens einer Halbleiteranordnung (2) nach einem der vorherigen Ansprüche.

14. Verfahren zur Herstellung einer Halbleiteranordnung (2), insbesondere einer Leistungshalbleiteranordnung für einen Stromrichter (50), mit zumindest einem Halbleiterelement (4), wobei das zumindest eine Halbleiterelement (4) in einem Gehäuse (6) angeordnet wird,
wobei das Gehäuse (6) zumindest teilweise mit einem rieselfähigen Werkstoff (30), welcher elektrisch isolierende Partikel enthält, derartig befüllt wird, dass der rieselfähige Werkstoff (30) mit dem zumindest einen Halbleiterelement (4) in unmittelbarem Kontakt steht,
wobei das Gehäuse (6) in einem weiteren Schritt verschlossenen wird.

15. Verfahren nach Anspruch 14,
wobei der rieselfähige Werkstoff (30) mit einem schmelzbaren Isolationsmaterial, insbesondere einem Wachs, verfüllt wird.

16. Verfahren nach Anspruch 14,
wobei der rieselfähige Werkstoff (30) mit einem isolierende Fluid verfüllt wird.

17. Verwendung eines rieselfähigen Werkstoffs (30), welcher elektrisch isolierende Partikel enthält, zum Befüllen eines Gehäuses (6) einer Halbleiteranordnung (2), in welchem zumindest ein Halbleiterelement (4) angeordnet ist,
wobei das Befüllen derartig erfolgt, dass der rieselfähige Werkstoff (30) mit dem zumindest einen Halbleiterelement (4) in unmittelbarem Kontakt steht.
